Europäisches Patentamt

European Patent Office

Office européen des brevets

(19)

(11) Veröffentlichungsnummer: **0 257 363**

**A1**

(12) EUROPÄISCHE PATENTANMELDUNG

(21) Anmeldenummer: 87111195.1

(22) Anmeldetag: 03.08.87

(51) Int. Cl.4: **H03K 21/40**

(30) Priorität: 04.08.86 DE 3626397

(43) Veröffentlichungstag der Anmeldung:
02.03.88 Patentblatt 88/09

(84) Benannte Vertragsstaaten:
AT BE CH DE ES FR GB IT LI LU NL SE

(71) Anmelder: **Siemens Aktiengesellschaft Berlin
und München**
**Wittelsbacherplatz 2**
**D-8000 München 2(DE)**

(72) Erfinder: **Schrenk, Hartmut, Dr.**
**Fasanenweg 22**
**D-8013 Haar(DE)**
Erfinder: **Pockrandt, Wolfgang, Dipl.-Phys.**
**Ilmstrasse 1**
**D-8069 Steinkirchen(DE)**

(54) Verfahren und Anordnung zur Erhöhung der möglichen Zählvorgänge eines digitalen Zählers mit nichtflüchtiger Zählerstandsspeicherung.

(57) Zur Erhöhung der möglichen Zählvorgänge eines digitalen Zählers (Z) mit nichtflüchtiger Speicherung des Zählerstands werden die niederwertigsten Bits des Zählerstands nicht in binärer Form nichtflüchtig abgespeichert, sondern codiert in einem ersten Teilspeicher (KS), der über eine Auswertelogik (AL) programmiert und ausgelesen wird und in dem jede Speicherzelle einer Bitkombination zugeordnet ist. Nach Speicherung der letzten Bitkombination erfolgt ein Übertrag in einen zweiten Teilspeicher (BS) zur nichtflüchtigen binären Speicherung der höherwertigen Bits des Zählerstands und der erste Teilspeicher (KS) wird gelöscht.

EP 0 257 363 A1

## Verfahren und Anordnung zur Erhöhung der möglichen Zählvorgänge eines digitalen Zählers mit nichtflüchtiger Zählerstandsspeicherung

Die Erfindung betrifft ein Verfahren und eine Anordnung, wie sie in den Oberbegriffen der Ansprüche 1 und 5 beschrieben sind.

Es gibt Anwendungen für digitale Zähler, beispielsweise als Kilometerzähler in einem Kraftfahrzeug, bei welchem die Notwendigkeit besteht, die Zählimpulse nichtflüchtig abzuspeichern, so daß bei Stromausfall der Zählerstand erhalten bleibt. Eine Schwierigkeit bei einem derartigen Zähler stellt die eingeschränkte Zahl der möglichen Umprogrammiervorgänge für eine nichtflüchtige Speicherzelle dar. Wenn man von einer Anzahl von 10 000 Umprogrammiervorgängen ausgeht, für die üblicherweise Speicherzellen spezifiziert sind, so ist damit die von einem nichtflüchtigen Sicherheitszähler geforderte Anzahl von Umprogrammierungen, die bei 10 Millionen liegt, nicht zu erfüllen.

Der Erfindung liegt die Aufgabe zugrunde, ein Verfahren und eine Anordnung der oben genannten Art anzugeben, bei denen die Zahl der möglichen Zählvorgänge des digitalen Zählers mit nichtflüchtiger Speicherung des Zählerstandes erhöht ist.

Diese Aufgabe wird gemäß dem kennzeichnenden Teil des Patentanspruchs 1 bzw. 5 gelöst.

Die Erfindung besitzt den Vorteil, daß die Anzahl der geforderten Zählvorgänge des digitalen Zählers abhängig von der Anzahl der möglichen Umprogrammiervorgänge je Speicherzelle mit einfachen Mitteln erhöht wird.

Weiterbildungen der Erfindung sind in Unteransprüchen gekennzeichnet.

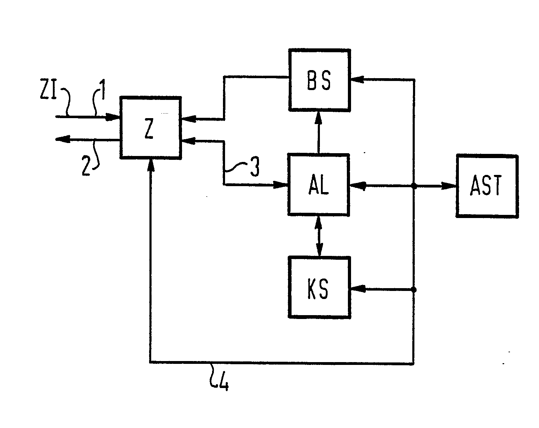

Im folgenden wird die Erfindung anhand eines Ausführungsbeispiels näher beschrieben. Die Figur der Zeichnung zeigt ein Blockschaltbild der Erfindung.

Die Anordnung gemäß der Figur besteht aus einem digitalen Zähler Z, dessen Zählerstand aufgrund von Zählimpulsen ZI auf einer Eingangsleitung 1 inkrementiert wird. Über die Ausgangsleitung 2 ist der aktuelle Zählerstand abgreifbar. Gesteuert von einer Ablaufsteuerung AST gelangt der Zählerstand des Zählers Z über einen Datenbus 3 zu einer Auswertelogik AL. Mit Hilfe der Auswertelogik werden nun gemäß der Erfindung die niederwertigsten Bits des Zählerstandes in einen nichtflüchtigen ersten Teilspeicher KS codiert gespeichert und die höherwertigen Bits des Zählerstandes in einem nichtflüchtigen zweiten Teilspeicher BS binär gemäß ihren Wertigkeiten gespeichert.

Umgekehrt kann auch der Inhalt der beiden Teilspeicher KS und BS in den Zähler Z zur Voreinstellung eines Zählerstandes eingeschrieben werden. Während dabei der Inhalt des ersten Teilspeichers KS immer über die Auswertelogik AL ausgewertet wird, kann der Inhalt des zweiten Teilspeichers BS entweder direkt in den Zähler Z oder aber ebenfalls über die Auswertelogik AL in den Zähler Z übernommen werden. Die Ansteuerung des Zählers Z, der Auswertelogik AL, des ersten Teilspeichers KS und des zweiten Teilspeicher BS durch die Ablaufsteuerung AST erfolgt über einen bidirektionalen Steuerbus 4. Unter der Annahme, daß der Zähler Z nach einer Zählanforderung einen bestimmten Zählerstand enthält, wird im folgenden die Inkrementierung des Zählers Z und die Speicherung des Zählerstandes beschrieben.

Beim Eintrefen eines Zählimpulses ZI wird der Zählerstand erhöht. Der neue Zählerstand wird über den Datenbus 3 in die Auswertelogik AL übernommen und ausgewertet. Den möglichen kombinationen der niederwertigsten Bits des Zählerstandes ist jeweils eine Speicherzelle des nichtflüchtigen ersten Teilspeichers fest zugeordnet. Bei der Inkrementierung des Zählers Z wird also die nächste Speicherzelle des ersten Teilspeichers programmiert. Mit jeder weiteren Inkrementierung des Zählers wird folglich die jeweils nächste Speicherzelle des ersten Teilspeichers programmiert, bis diejenige Speicherzelle beschrieben ist, die der letzten Bitkombination der niederwertigsten Bits, d.h. lauter logischen "1"-Zuständen entspricht.

Bei einer erneuten Inkrementierung des Zählers Z erfolgt ein Übertrag in den nichtflüchtigen zweiten Teilspeicher, in dem der den höherwertigen Bits entsprechende Teil-Zählerstand entsprechend den binären Wertigkeiten abgespeichert ist. Gleichzeitig oder anschließend wird der nichtflüchtige erste Teilspeicher insgesamt gelöscht und mit dem nächsten Zählimpuls ZI beginnt der Vorgang, d.h. die Programmierung der den niederwertigsten Bits des Zählerstandes zugeordneten codierten Speicherzellen von vorne.

Der erste Teilspeicher enthält mindestens soviele Speicherzellen, wie Bitkombinationen des abzuspeichernden binären niederwertigsten Teil-Zählerstandes existieren. Vorzugsweise sind die Speicherzellen des ersten Teilspeichers matrixförmig organisiert. Mit Hilfe der Auswertelogik AL kann aber der erste Teilspeicher KS nicht nur beschrieben, sondern auch ausgewertet werden. Dazu stellt die Auswertelogik AL die letzte programmierte Speicherzelle des ersten Teilspeichers KS fest und generiert die dieser Speicherzelle zugeordnete Bitkombination, die zusammen mit der im zweiten Teilspeicher BS gespeicherten Bitkombination den abgespeicherten Zählerstand ergibt. Gegebenenfalls, z. B. bei einer Zählanforderung, kann dieser aktuelle Zählerstand in den Zähler Z übernommen werden.

Andererseits werden zum Vorladen der beiden Teilspeicher KS und BS mit einem vorgegebenen Zählerstand zunächst beide Teilspeicher KS und BS insgesamt gelöscht. Danach wird mit Hilfe der Auswertelogik die Speicherzelle festgestellt, die dem sich aus den niederwertigsten Bits ergebenden Teil-Zählerstand zugeordnet ist, und in diese Speicherzelle wird einschließlich der untergeordneten, niedrigeren Teil-Zählerstanden zugeordneten Speicherzellen im ersten Teilspeicher KS programmiert. Die höherwertigen Bits des Zählerstandes werden entsprechend ihren binären Wertigkeiten in den Speicherzellen des zweiten Teilspeichers BS abgespeichert.

Die Anzahl der niederwertigsten Bits des Zählers Z, die auf die oben beschriebene Art codiert gespeichert werden müssen und damit die Größe des ersten Teilspeichers bzw. der Speichermatrix hängt ab von der Anzahl der geforderten Zählvorgänge und der Anzahl der möglichen Umprogrammierungsvorgänge je Speicherzelle. Je größer die Zahl der geforderten Zählvorgänge ist, desto größer muß folglich bei einer vorgegebenen möglichen Zahl der Umprogrammiervorgänge je Speicherzelle die Anzahl der Speicherzellen des ersten Speichers KS sein.

Die Ausgestaltung der Auswertelogik AL entspricht dem einem Fachmann geläufigen Können. So läßt sich eine erfindungsgemäße Anordnung beispielsweise für EEPROMs vorsehen, die gemäß dem Stand der Technik z.B. in n-Kanal-Doppelpoly-Floating-Gate-Technik ausgeführt sein können.


## Ansprüche

1. Verfahren zur Erhöhung der möglichen Zählvorgänge eines digitalen Zählers mit nicht flüchtiger Speicherung des Zählerstandes, wobei Speicherzellen zur Aufnahme von Zählerständen vorhanden sind,
**dadurch gekennzeichnet,**
-daß für die niederwertigsten Bits eines aktuellen Zählstandes ein nichtflüchtiger erster Teilspeicher (KS) programmiert wird, dessen Speicherzellen jeweils einem entsprechenden Teil-Zählerstand zugeordnet sind und
-daß die höherwertigen Bits in einem nichtflüchtigen zweiten Teilspeicher (BS) abgespeicher werden, dessen Speicherzellen den binären Wertigkeiten der höherwertigen Bits zugeordnet sind.

2. Verfahren nach Anspruch 1, **dadurch gekennzeichnet,**
-daß bei jeder Inkrementierung des Zählers (Z) die jeweils nächste Speicherzelle des ersten Teilspeichers (KS) programmiert wird, die dem sich aus den niederwertigsten Bits ergebenden Teil-Zählerstand fest zugeordnet ist,
-daß nach der Programmierung der letzten Speicherzelle des ersten Teilspeichers (KS) ein Übertrag in den zweiten Teilspeicher (BS) erfolgt, der dessen sich aus den binär gewichteten höherwertigen Bits ergebenden Teil-Zählerstand erhöht und
-daß danach der erste Teilspeicher (KS) insgesamt gelöscht wird.

3. Verfahren nach Anspruch 1 oder 2, **dadurch gekennzeichnet,**
-daß für die Übernahme des letzten aktuellen Zählerstandes in den Zähler (Z) die letzte programmierte Speicherzelle des ersten Teilspeichers (KS) mit Hilfe einer Auswerte logik (AL) festgestellt wird,
-daß die dieser Speicherzelle zugeordnete Bitkombination generiert wird und
-daß diese Bitkombination zusammen mit dem Inhalt des zweiten Teilspeichers (BS) den Wertigkeiten entsprechend in den Zähler (Z) übernommen wird.

4. Verfahren nach Anspruch 1, **dadurch gekennzeichnet,**
-daß zum Vorladen der beiden Teilspeicher (KS, BS) mit einem vorgegebenen Zählerstand zunächst beide Teilspeicher (KS, BS) gelöscht werden,
-daß dann die Speicherzelle, die dem sich aus den niederwertigsten Bits ergebenden Teil-Zählerstand zugeordnet ist, mit Hilfe der Auswertelogik (AL) festgestellt und einschließlich der untergeordneten, niedrigeren Teil-Zählerständen zugeordneten Speicherzellen im ersten Teilspeicher (KS) programmiert wird und
-daß die höherwertigen Bits des Zählerstands entsprechend ihren binären Wertigkeiten in den Speicherzellen des zweiten Teilspeichers (BS) abgespeichert werden.

5. Anordnung zur Durchführung des Verfahrens nach Anspruch 1 bis 4, **gekennzeichnet** durch einen digitalen Zähler (Z), einen ersten Teilspeicher (KS), einer Auswertelogik (AL) zur Programmierung und Auslesung codierter Speicherzellen des ersten Teilspeichers (KS), die einem binären niederwertigsten Teil-Zählerstand zugeordnet sind, einen zweiten Teilspeicher (BS) zur binären Speicherung eines binären höherwertigen Teil-Zählerstandes sowie eine Ablaufsteuerung (AST).

6. Anordnung nach Anspruch 5, **dadurch gekennzeichnet,**
daß der erste Teilspeicher (KS) mindestens soviele Speicherzellen enthält wie Bitkombinationen des abzuspeichernden binären niederwertigsten Teil-Zählerstands existieren.

7. Anordnung nach Anspruch 5, **dadurch gekennzeichnet,**
daß der erste Teilspeicher (KS) matrixförmig organisierte Speicherzellen besitzt.

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (Int. Cl.4) |
|---|---|---|---|
| X | EP-A-0 070 461 (DEUTSCHE ITT INDUSTRIES GmbH) * Figur 1; Seite 2, Zeile 32 - Seite 7, Zeile 26 * --- | 1-7 | H 03 K 21/40 |
| P,X | GB-A-2 171 543 (HUGHES MICROELECTRONICS LTD) * Figur 1; Seite 1, Zeile 44 - Seite 2, Zeile 117 * ----- | 1 | |

RECHERCHIERTE
SACHGEBIETE (Int. Cl.4)

H 03 K

Der vorliegende Recherchenbericht wurde für alle Patentansprüche erstellt

| Recherchenort | Abschlußdatum der Recherche | Prüfer |
|---|---|---|
| DEN HAAG | 03-11-1987 | FEUER F.S. |